# EUROPEAN PATENT APPLICATION

(11) **EP 3 153 941 A1**
(43) Date of publication of application: **12.04.2017**
(21) Application number: 15193491.6
(22) Date of filing: 06.11.2015
(51) Int. Cl.: G06F 1/16, H05K 5/02, G06K 7/00

(54) **CLASP, BRACELET, PROCESS OF MANUFACTURE, AND USE THEREOF**

(30) Priority: 08.10.2015 EP 15189036
(71) Applicant: Pim GmbH, 73760 Ostfildern (DE)
(72) Inventor: Buyruk, Sinem, 73728 Esslingen (DE); Uzun, Polat, 73760 Ostfildern (DE)
(74) Representative: Meyer zu Bexten, Elmar

(57) **Abstract**

Problem

The invention aims to unite a serial bus connection cable and independent flash drive in a functional but stylish clasp and bracelet.

Solution

Clasp (A1-E1) comprising
a USB connector housing (E1) for housing a standard-A USB plug,
a USB connector cover (B1) joined to the USB connector housing (E1) for covering the plug inside the USB connector housing (E1),
an open-end bus connector housing (D1) for housing a male bus connector such that the bus connector protrudes from the bus connector housing (D1),
a bus connector cover (C1) joined to the bus connector housing (D1) for covering the bus connector inside the bus connector cover (C1), and
a USB flash housing (A1) attached to the USB connector cover (B1) for housing a USB flash drive sandwiched betwixt the USB flash housing (A1) and the USB connector cover (B1),
wherein the USB connector housing (E1) is recessed such that, when the bus connector cover (C1) is unilaterally aligned to the USB connector housing (E1), the USB connector housing (E1) receives the protruding bus connector.

## Description

### Technical Field

The invention pertains to the fields of fastening and consumer electronics.

### Background Art

In mechanical engineering, by fastener is meant any hardware device that mechanically joins or affixes two or more objects together. More specifically, a clasp is a fastener for holding together two things or parts of the same thing. Where said parts are opposite ends of a strap or belt, the clasp may also be called a buckle.

State-of-the-art clasps have been incorporated into so-called smart bands, that is, electronic gadgets in the format of wristbands or armbands. An exemplary activity tracker comprising a wristband and removable clasp has been described in INGBER, Janet. Get in Shape with the Fitbit Flex. AFB AccessWorld Magazine. August 2014, vol.15, no.8. Moreover, prior art US 2004151071 A (KOCHER ROBERT WILLIAM) 05.08.2004 discloses a wristband and clasp housing a standard Universal Serial Bus (USB) connector covered by a clasp component.

### Summary of invention

The invention aims to unite a serial bus connection cable and independent flash drive in a functional but stylish clasp and bracelet. The invention further concerns a process specially adapted for the manufacture of such bracelet and a method of using the same.

### Technical Problem

To achieve an optimal design, the invention strives to hide the two ports that characterize an embodiment. To this end, the various functional units need to be combined and integrated in the tightest of spaces. Specifically, relative to known apparatus that fulfil only a single function, any distinct increase in size of the aggregate product is to be avoided. Still, an embodiment of the invention should allow for a simple and comfortable handling. Therefore, the relevant components of the clasp must be easy to reach and grasp.

It is a further object of the invention to provide a bracelet comprising such clasp that may be securely and reversibly fastened while avoiding a bulky and unsightly form factor.

### Solution to Problem

The problem is solved by a specific and intricate plug-and-click mechanism as claimed.

### Advantageous effect of invention

The proposed clasp integrates a plurality of functional modules in a compact form factor while retaining their separate accessibility.

### Brief description of drawings

Figure 1 is an exploded view of the clasp.
Figure 2 is a plan view of the USB flash housing.
Figure 3 is a cross-section taken through AB of Figure 2.
Figure 4 is a side elevation of the USB flash housing.
Figure 5 is a bottom view of the USB flash housing.
Figure 6 is a cross-section taken through CD of Figure 3.
Figure 7 and Figure 8 are perspective views of the USB connector cover.
Figure 9 is a plan view of the USB connector cover.
Figure 10 is a cross-section taken through AB of Figure 9.
Figure 11 is a side elevation of the USB connector cover.
Figure 12 is a bottom view of the USB connector cover.
Figure 13 is a cross-section taken through CD of Figure 12.
Figure 14 is a detail Z of Figure 9.
Figure 15 is an end elevation of the USB connector cover looking into the direction of the arrows C and D of Figure 12.
Figure 16 is an end elevation of the USB connector cover looking into the opposite direction.
Figure 17 is a view of the bracelet.
Figure 18, Figure 19, and Figure 20 are partial views of the bracelet banded around a wearer's wrist.

All linear dimensions are given in millimeters.

### Description of embodiments

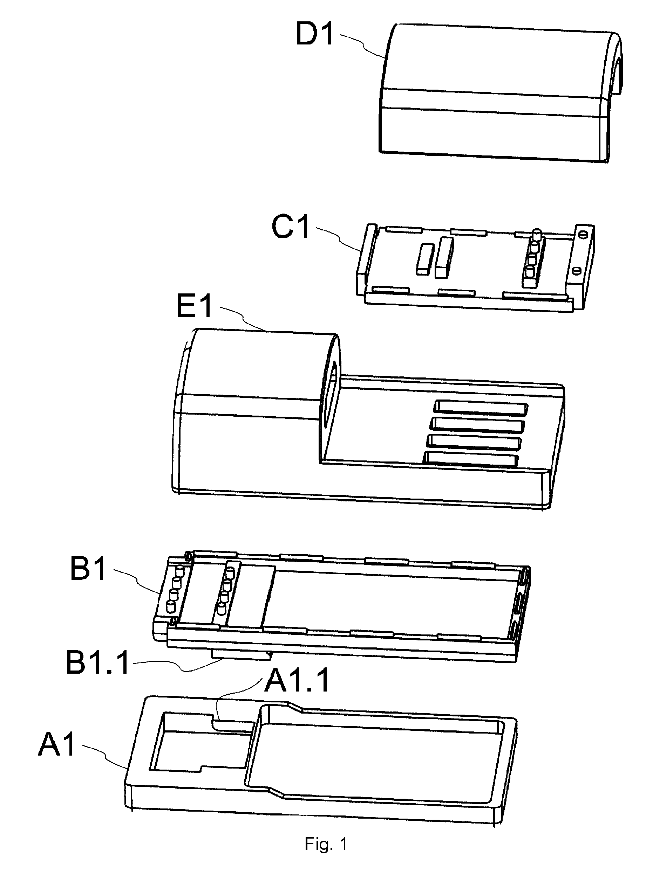

Figure 1 illustrates a clasp (A1-E1) comprising a USB connector housing (E1) for housing a standard-A USB plug as well as a recessed USB connector cover (B1) joined to the USB connector housing (E1). The clasp (A1-E1) further comprises an open-end bus connector housing (D1), a bus connector cover (C1) joined to the bus connector housing (D1), and a USB flash housing (A1) attached to the USB connector cover (B1). Selectively, the bus connector housing (D1) and the bus connector cover (C1) may be shaped to accommodate a micro-B USB plug or Lightning® connector.

As is readily apparent from the drawing, the bus connector cover (C1) and the bus connector housing (D1) are shaped to merge smoothly with the USB connector housing (E1) when properly aligned. For these and other parts of the clasp (A1-E1), injection moulding is employed as a preferred manufacturing technique.

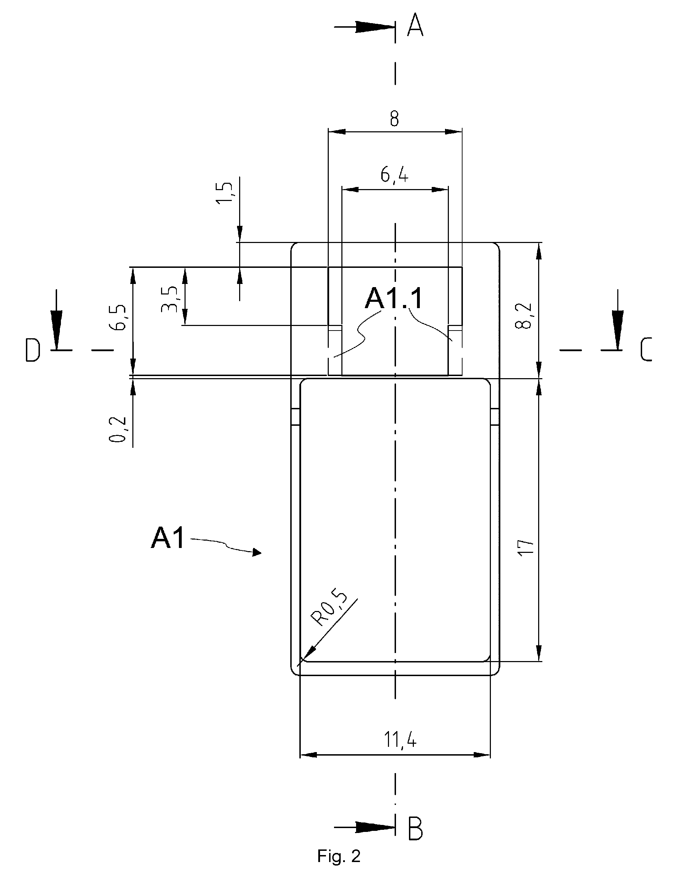

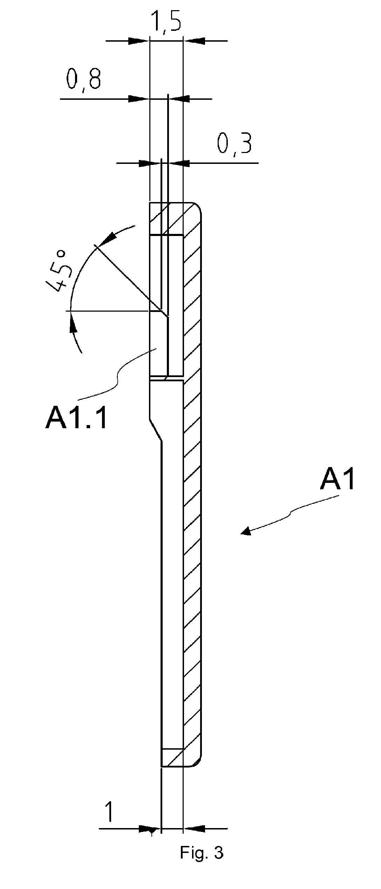

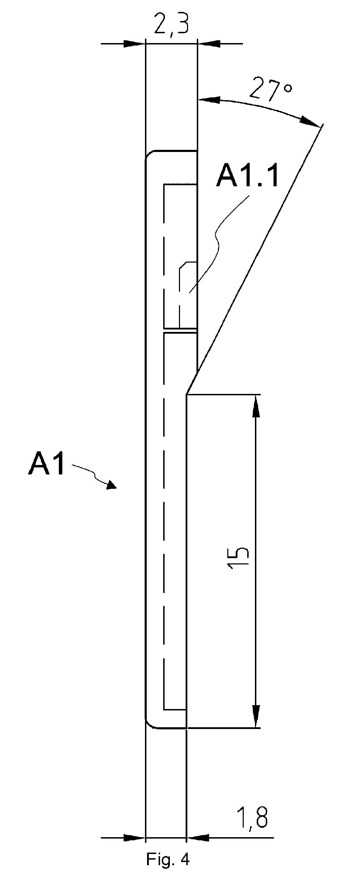

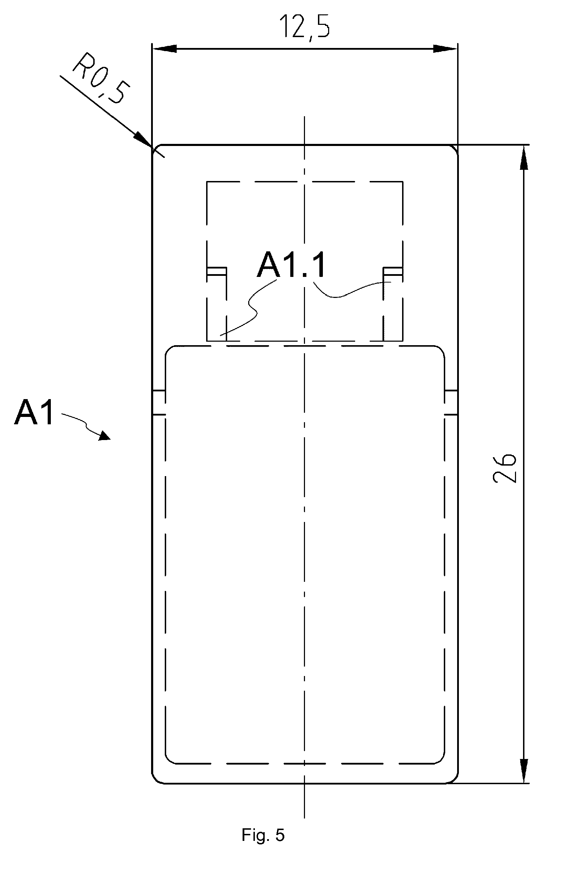

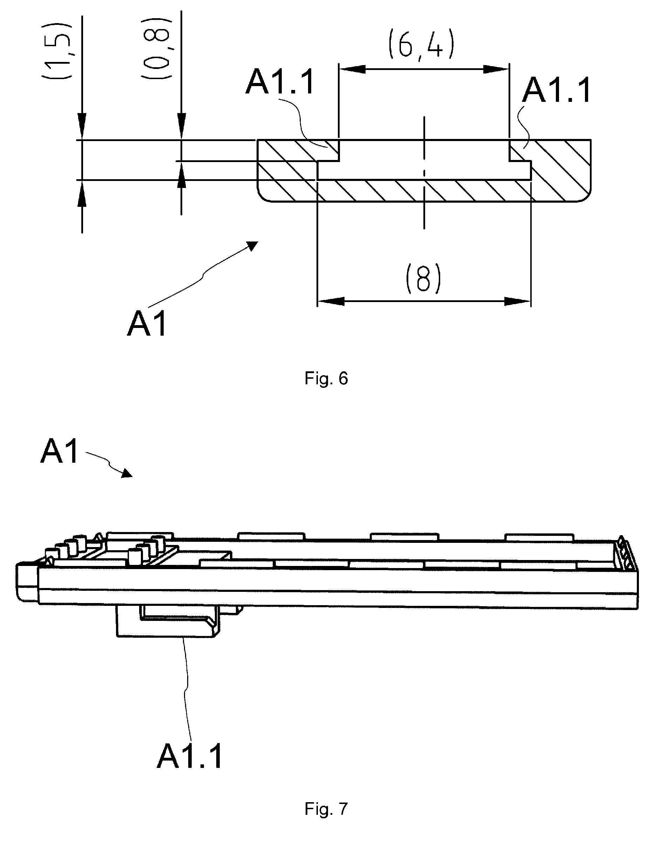

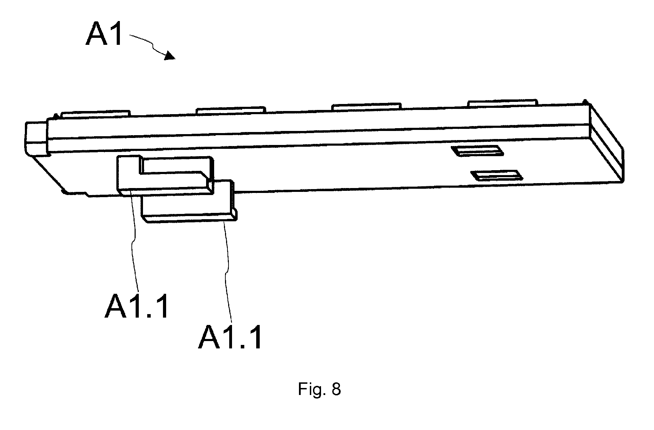

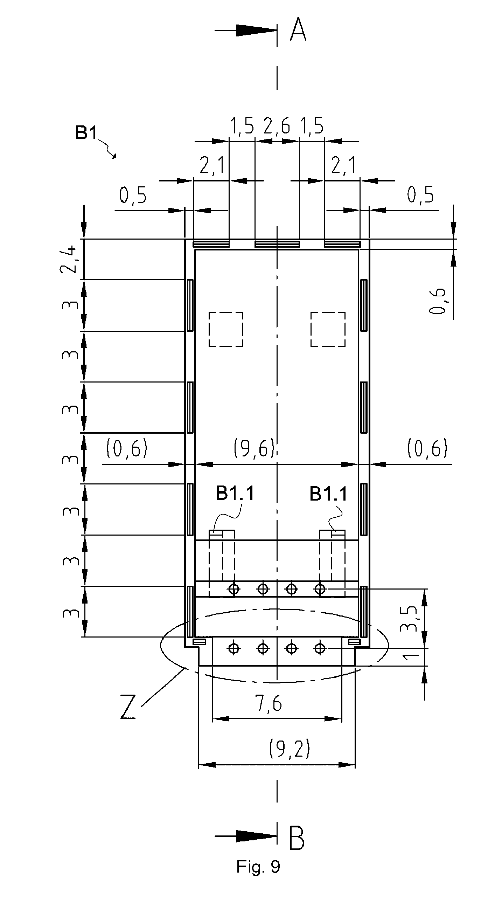

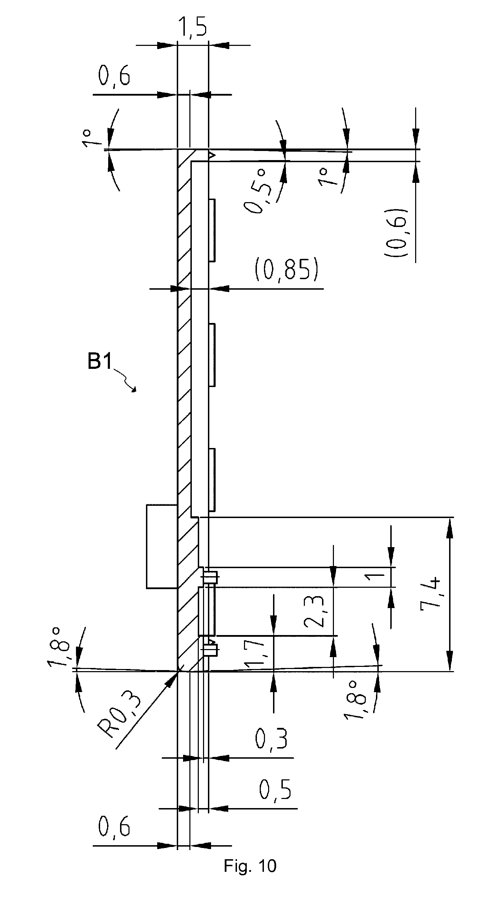

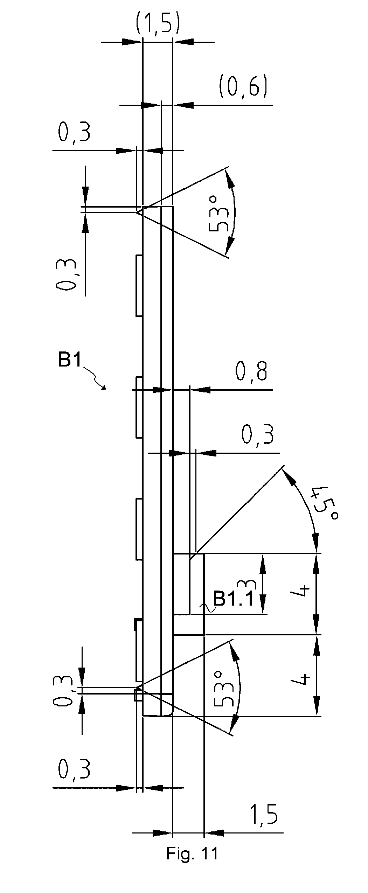

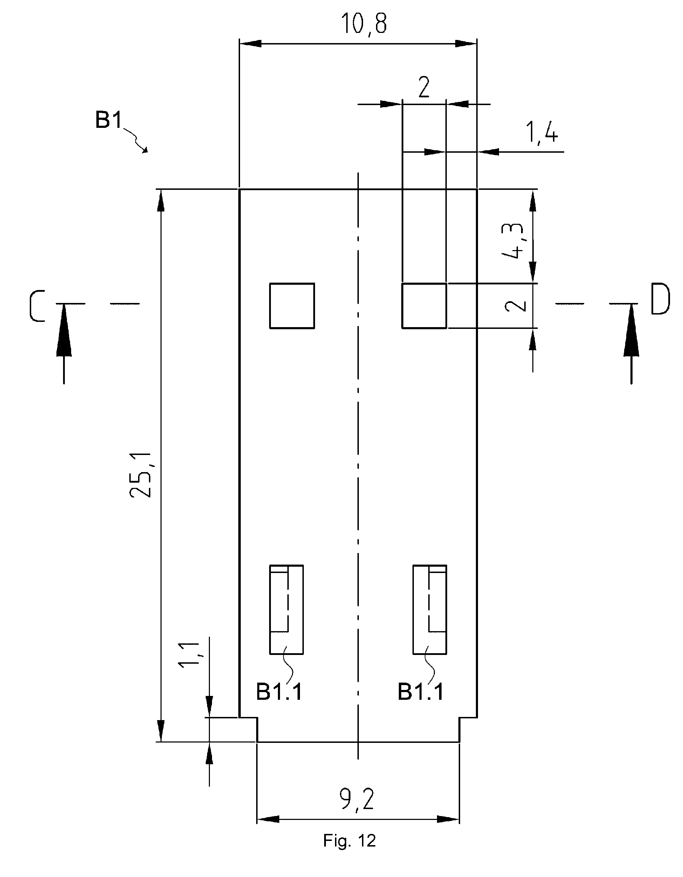

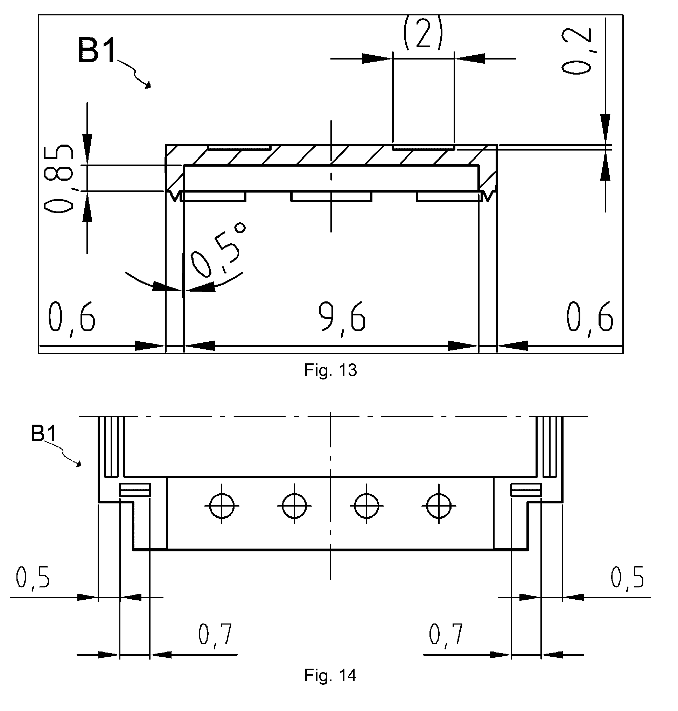

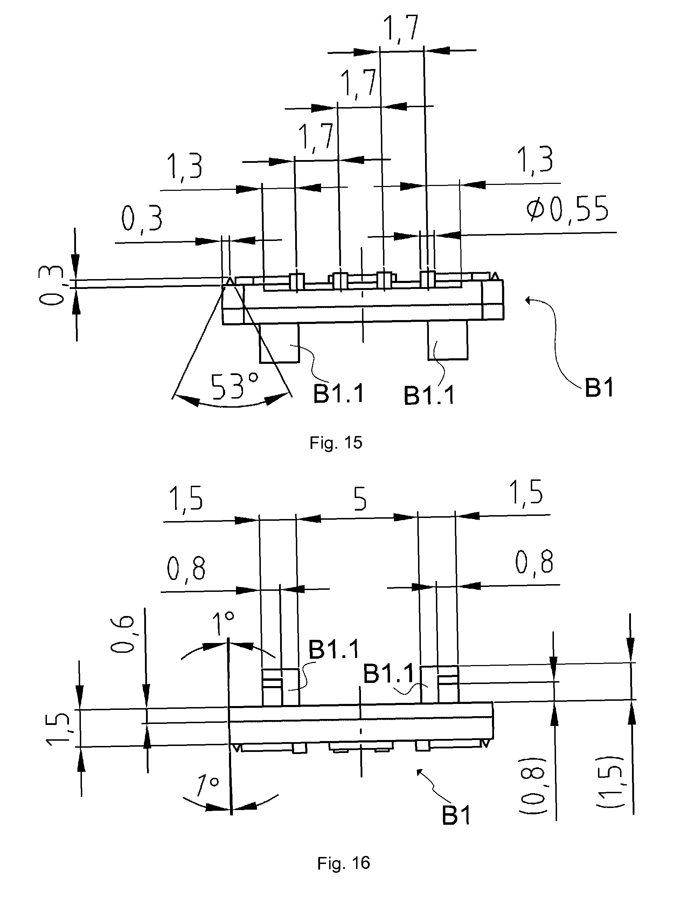

Figure 2 to Figure 6 and Figure 7 to Figure 16 depict the USB flash housing (A1) and USB connector cover (B1), respectively, in further detail. When considered in combination, these two sets of drawings elucidate the mutual force action brought about by - on the part of the USB flash housing (A1) - a pair of facing salients (A1.1) and - on the part of the USB connector cover (B1) - a pair of bilateral hooks (B1.1), wherein each hook (B1.1) engages behind one of the salients (A1.1) when the USB flash housing (A1) is attached to the USB connector cover (B1). More specifically, the salients (A1.1) and the hooks (B1.1) are shaped such that, when the USB flash housing (A1) is slid alongside the USB connector cover (B1), the hooks (B1.1) disengage from the salients (A1.1), allowing the USB flash housing (A1) to detach from the USB connector cover (B1) altogether.

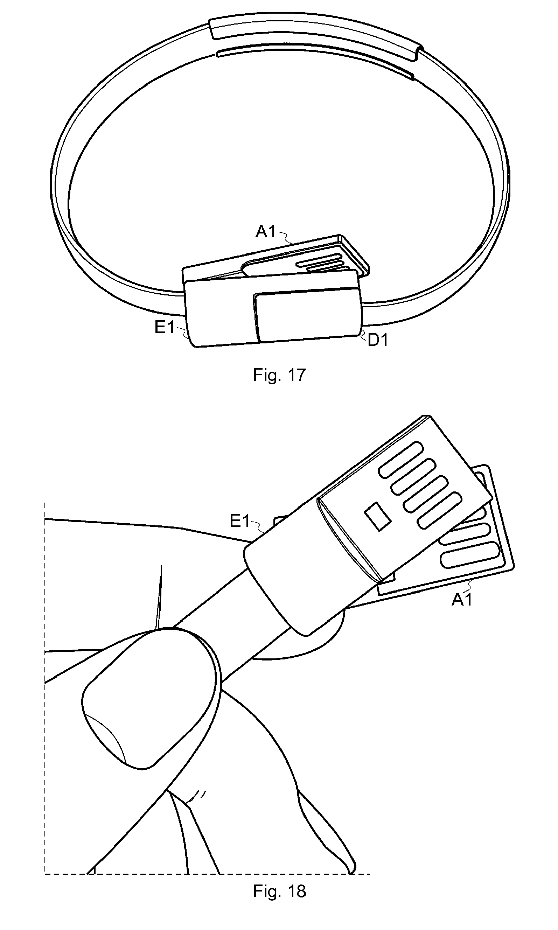

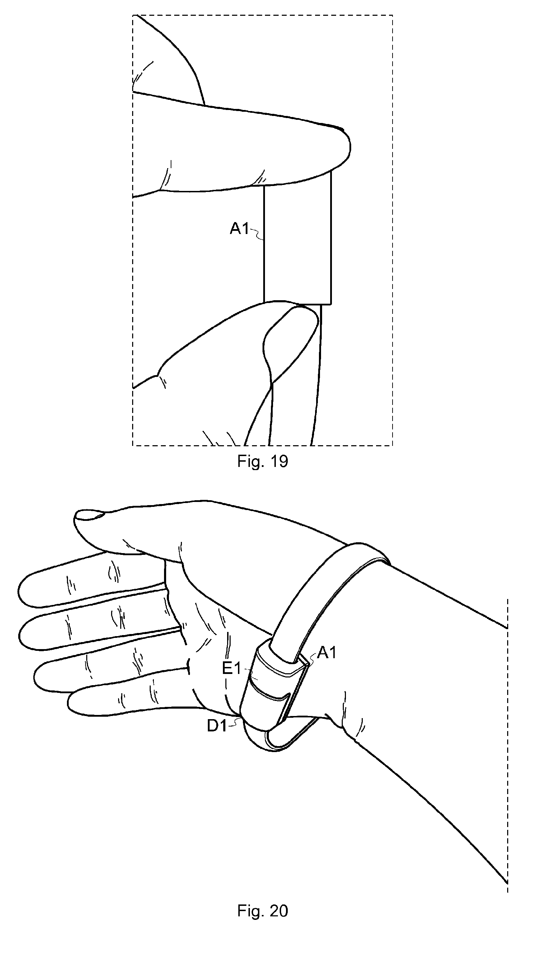

Figure 17 to Figure 20 depict a bracelet comprising the clasp (A1-E1). Here, a USB flash drive is housed by the USB flash housing (A1) and sandwiched betwixt the USB flash housing (A1) and the USB connector cover (B1). Further, a bus connector is housed by the bus connector housing (D1) and covered by the bus connector cover (C1), providing a storage capacity of at least 4, 8, 16, 32, 64, or 128 GB. A standard-A USB plug is housed by the USB connector housing (E1), covered by the USB connector cover (B1), and connected to the bus connector over a distance of approximately 22 cm by a flexible wristband of acrylonitrile butadiene styrene (ABS) with a thermoplastic elastomer (TPE) surface. With the bus connector cover (C1) being unilaterally aligned to the USB connector housing (E1), the latter receives that part of the bus connector that protrudes from its bus connector housing (D1). To achieve an esthetically pleasing overall effect, the USB flash housing (A1), the bus connector housing (D1), the USB connector housing (E1), and the wristband are of a uniform yet lively color - not depicted - such as blue, green, red, gray, or green.

### Industrial applicability

The invention is applicable, inter alia, throughout the apparel and jewelry industries.

### Reference signs list

Similar reference characters denote corresponding features consistently throughout the attached drawings.

| | |
|---|---|
| A1 | USB flash housing |
| A1.1 | Salients |
| B1 | USB connector cover |
| B1.1 | Hooks |
| C1 | Bus connector cover |
| D1 | Bus connector housing |
| E1 | USB connector housing |

### Citation list

The following literature is cited throughout this document.

### Patent literature

US 2004151071 A (KOCHER ROBERT WILLIAM) 05.08.2004

### Non-patent literature

INGBER, Janet. Get in Shape with the Fitbit Flex. AFB AccessWorld Magazine. August 2014, vol. 15, no.8.

## Claims

1. Clasp (A1-E1) comprising
a USB connector housing (E1) for housing a standard-A USB plug and
a USB connector cover (B1) joined to the USB connector housing (E1) for covering the plug inside the USB connector housing (E1),
**characterized in**
an open-end bus connector housing (D1) for housing a male bus connector such that the bus connector protrudes from the bus connector housing (D1),
a bus connector cover (C1) joined to the bus connector housing (D1) for covering the bus connector inside the bus connector cover (C1), and
a USB flash housing (A1) attached to the USB connector cover (B1) for housing a USB flash drive sandwiched betwixt the USB flash housing (A1) and the USB connector cover (B1),
wherein the USB connector housing (E1) is recessed such that, when the bus connector cover (C1) is unilaterally aligned to the
USB connector housing (E1), the USB connector housing (E1) receives the protruding bus connector.

2. Clasp (A1-E1) according to Claim 1,
**characterized in that**
the USB flash housing (A1) comprises facing salients (A1.1) and
the USB connector cover (B1) comprises bilateral hooks (B1.1), each hook (B1.1) engaging behind one of the salients (A1.1),
wherein the salients (A1.1) and the hooks (B1.1) are shaped such that, when the USB flash housing (A1) is slid alongside the USB connector cover (B1), the hooks (B1.1) disengage from the salients (A1.1) and the USB flash housing (A1) detaches from the USB connector cover (B1).

3. Clasp (A1-E1) according to Claim 1 or Claim 2,
**characterized in that**
the bus connector cover (C1) and the bus connector housing (D1) are shaped to accommodate a micro-B USB plug.

4. Clasp (A1-E1) according to Claim 1 or Claim 2,
**characterized in that**
the bus connector cover (C1) and the bus connector housing (D1) are shaped to accommodate a Lightning connector.

5. Clasp (A1-E1) according to any of the preceding claims,
**characterized in that**
the bus connector cover (C1) and the bus connector housing (D1) are shaped to merge smoothly with the USB connector housing (E1) when properly aligned.

6. Bracelet,
**characterized in**
a clasp (A1-E1) according to any of the preceding claims,
a USB flash drive housed by the USB flash housing (A1) and sandwiched betwixt the USB flash housing (A1) and the USB connector cover (B1),
a bus connector housed by the bus connector housing (D1) and covered by the bus connector cover (C1),
a standard-A USB plug housed by the USB connector housing (E1) and covered by the USB connector cover (B1), and
a wristband connecting the bus connector to the plug.

7. Bracelet according to Claim 6,
**characterized in that**
the wristband is of acrylonitrile butadiene styrene with a thermoplastic elastomer surface.

8. Bracelet according to Claim 6 or Claim 7,
**characterized in that**
at least the USB flash housing (A1), the bus connector housing (D1), the USB connector housing (E1), and the wristband are of a uniform color, preferably blue, green, red, gray, or green.

9. Bracelet according to any of Claim 6 to Claim 8,
**characterized in that**
the wristband measures 22 cm.

10. Bracelet according to any of Claim 6 to Claim 9,
**characterized in that**
the USB flash drive has a storage capacity of at least 4, 8, 16, 32, 64, or 128 GB.

11. Process for the manufacture of a bracelet according to any of Claim 6 to Claim 10,
**characterized in**
injection molding the USB flash housing (A1), the USB connector cover (B1), the bus connector cover (C1), the bus connector housing (D1), and the USB connector housing (E1),
housing the USB flash drive in the USB flash housing (A1),
sandwiching the USB flash drive betwixt the USB flash housing (A1) and the USB connector cover (B1) by attaching the USB flash housing (A1) to the USB connector cover (B1),
housing the bus connector in the bus connector housing (D1),
covering the bus connector by joining the bus connector cover (C1) to the bus connector housing (D1),
housing the plug in the USB connector housing (E1),
covering the plug by joining the USB connector cover (B1) to the USB connector housing (E1), and
connecting the bus connector to the plug through the wristband.

12. Method of using a bracelet according to any of Claim 6 to Claim 10,
**characterized in**,
as required, unclasping the bracelet by unplugging the bus connector from the USB connector housing (E1),
connecting the bus connector to a complementary bus receptacle of a mobile device, and
plugging the plug into a standard-A USB receptacle.

13. Method according to Claim 12,
**characterized in**
charging the mobile device through the wristband,
wherein the receptacle is provided by a portable, preferably rechargeable battery.

14. Method according to Claim 12,
**characterized in**
a serial data transfer through the wristband,
wherein the receptacle is provided by a USB host.

15. Method according to any of Claim 12 to Claim 14,
**characterized in**,
as required, detaching the USB flash housing (A1) from the USB connector and
plugging the USB flash drive into the standard-A USB receptacle.
